# EUROPÄISCHE PATENTSCHRIFT

(11) **EP 1 083 599 B1**
(45) Veröffentlichungstag und Bekanntmachung des Hinweises auf die Patenterteilung: **25.07.2007**
(21) Anmeldenummer: 00119604.7
(22) Anmeldetag: 07.09.2000
(51) Int. Cl.: H01L 23/051, H01L 23/40

(54) **Leistungshalbleitermodul**
Power semiconductor module
Dispositif semiconducteur de puissance

(30) Priorität: 08.09.1999 DE 19942915
(43) Veröffentlichungstag der Anmeldung: 14.03.2001
(73) Patentinhaber: STILL GMBH, D-22113 Hamburg (DE)
(72) Erfinder: Fromme, Georg, Dr.-Ing., 22145 Hamburg (DE); Suchanek, Joseph, Dipl.-Ing., 21079 Hamburg (DE)
(74) Vertreter: Geirhos, Johann

(56) Entgegenhaltungen:
- DE-A1- 3 508 456
- DE-A1- 19 707 514
- DE-A1- 19 715 540
- US-A- 4 853 762

## Beschreibung

Die Erfindung betrifft ein Leistungshalbleitermodul mit einem elektrisch isolierenden und thermisch leitenden Substrat, auf dessen Oberfläche elektrische Kontaktflächen und mindestens ein mit diesen elektrisch leitend verbundener Leistungshalbleiter angeordnet sind, und mit einer Anpreßvorrichtung, mit der die Unterseite des Substrates zumindest teilweise mit einem Kühlkörper in thermischen Kontakt gebracht wird. Ferner bezieht sich die Erfindung auf einen mehrphasigen Umrichter mit mehreren elektrischen Halbbrücken, die jeweils aus zwei in Reihe geschalteten Leistungsschaltern bestehen, wobei die Verbindungen zwischen den zwei Leistungsschaltern jeweils einen Ausgang des Umrichters darstellen.

Elektronische Leistungsschalter zählen zu den wesentlichen Bestandteilen von elektronischen Leistungsstellern, die zur Speisung von elektrischen Antriebsmaschinen eingesetzt werden. In Abhängigkeit vom gewählten Antriebskonzept werden diese Leistungsschalter in unterschiedlichen Kombinationen, beispielsweise als Gleichstromsteller oder als dreiphasiger Umrichter für eine Drehfeldmaschine, zusammengeschaltet.

Elektronische Leistungsschalter werden heute anwendungs- und herstellerspezifisch mit unterschiedlichen Halbleitertechnologien in verschiedenen Aufbauformen realisiert. Um die geforderte Stromtragfähigkeit zu erzielen, werden häufig mehrere Halbleiterchips parallel geschaltet.

Beim Aufbau der elektronischen Leistungsschalter sind verschiedene Randbedingungen zu berücksichtigen. Zunächst ist für eine ausreichende Befestigung der Halbleiterchips und eines ersten und eines zweiten elektrischen Leistungsanschlusses auf einem Grundkörper, in der Regel einem elektrisch isolierenden Substrat, meist einem sogenannten DCB-Substrat, zu sorgen. Bei Leistungsschaltern, die hohen Strombelastungen ausgesetzt werden, sind gegebenenfalls weitere Halbleiterchips parallel zu schalten. Zur Steuerung des Leistungsschalters ist ein entsprechender Steueranschluß zu realisieren, der bei Parallelschaltung mehrerer Halbleiterchips meist mit einem Entkopplungsnetzwerk versehen wird. Aufgrund der hohen Schaltgeschwindigkeit moderner Leistungshalbleiter ist ein möglichst induktivitätsarmer und niederohmiger Aufbau anzustreben, um eine Zerstörung der Halbleiterbauelemente durch Spannungsspitzen auszuschließen.

In der Regel müssen die Halbleiterchips an ein Kühlsystem angekoppelt werden, um die in den Halbleiterchips in Form von Wärme entstehende Verlustleistung abzuführen. Hierbei ist darauf zu achten, daß die Chips sowohl gegenüber dem Kühlsystem als auch gegenüber dem Gehäuse elektrisch isoliert sind. Der Aufbau ist ferner so auszulegen, daß er eine ausreichende thermische Zyklenfestigkeit aufweist und die Halbleiterchips gegen Umwelteinflüsse, wie zum Beispiel Feuchtigkeit und Schmutz, schützt.

Es sind bereits zahlreiche Aufbauformen beschrieben worden, die die obengenannten Funktionen mehr oder weniger gut erfüllen. Den elektrischen Anforderungen, insbesondere dem induktivitätsarmen Aufbau, wird in der EP 0 265 833 dadurch Rechnung getragen, daß mit dem Sourcekontakt der MOSFETs ein Hilfsanschluß verbunden ist, und daß die beiden Leistungsanschlüsse als U-förmige ineinander verschachtelte Leiter ausgebildet sind.

Die DE35 08 456 A1 zeigt ein Leistungshalbleitermodul mit einer Anpressvorrichtung für das Substrat, die von diesem durch ein Zwischenstück aus Kunststoff isoliert ist.

In der DE 43 38 107 C1 ist ein Halbleitermodul beschrieben, welches Halbleiterchips aufweist, die auf der Oberseite eines elektrisch isolierenden und thermisch leitenden Substrats angebracht sind. Das Substrat ist stoffschlüssig mit der Oberseite einer Metallbodenplatte verbunden, deren Unterseite konvex ausgebildet ist. Die Metallbodenplatte wird an ihren Enden an einem Kühlkörper angeschraubt, so daß die Bodenplatte mit ihrer ganzen Fläche am Kühlkörper anliegt, um einen einwandfreien thermischen Kontakt zwischen ihr und dem Kühlkörper auch während des Betriebs des Halbleitermoduls zu ermöglichen.

Ferner sind Aufbauformen gemäß der IMS-Technologie bekannt. Bei dieser Technologie ist ein mehrschichtiger monolithischer Aufbau vorgesehen, bestehend aus Kühlkörper, Isolierfolie und geätzten Kupferflächen mit aufgelöteten Leistungshalbleitern in SMD-Gehäuse (Surface Mounted Device) oder mit aufgelöteten Halbleiterchips.

Ebenso ist bekannt, einzelne Leistungshalbleiter in Standardgehäuseformen isoliert auf Kühlkörper zu montieren, und die elektrischen Verbindungen über eine Leiterplatte herzustellen.

Aufgabe vorliegender Erfindung ist es, ein Leistungshalbleitermodul der eingangs genannten Art zu entwickeln, welches sich durch einen einfachen Aufbau auszeichnet und unter Betriebsbedingungen einen ausreichenden thermischen Kontakt des Substrats mit dem Kühlkörper gewährleistet.

Diese Aufgabe wird dadurch gelöst, daß die Anpreßvorrichtung als elektrische Zuleitung zu den elektrischen Kontaktflächen dient. Die Funktionen "Anpressen" des Substrates und "Kontaktierung" des Substrates werden erfindungsgemäß in einem Bauelement vereint. Die Leistungshalbleiter sowie weitere elektrische und elektronische Bauelemente, die mit den elektrischen Kontaktflächen verbunden sind, werden über die Anpreßvorrichtung elektrisch angeschlossen.

Das erfindungsgemäße Leistungshalbleitermodul besteht vorzugsweise aus einem Substrat, auf dem die erforderliche Anzahl von Leistungshalbleitern in einer Reihe nebeneinander angeordnet ist. Das Substrat besitzt eine Form, vorzugsweise Rechteckform, mit einer durch die Abmessungen der Leistungshalbleiter vorgegebenen möglichst geringen Breite. Unter Länge und Breite des Substrates werden die Abmessungen in der Ebene der Substratoberfläche verstanden, wobei mit Länge die größere der beiden Substratabmessungen bezeichnet wird.

Die Leistungshalbleiter sind rechtwinklig zur Längsrichtung des Substrates nebeneinander in einer Reihe angeordnet, wobei der geringstmögliche zulässige Abstand zwischen den Leistungshalbleitern gewählt wird. Auf diese Weise wird ein äußerst platzsparender Aufbau erzielt. Hinsichtlich der Anzahl der parallel geschalteten Leistungshalbleiter auf einem Substrat besteht größtmögliche Flexibilität, da, ohne die Grundstruktur des Aufbaus, nämlich die Anordnung in einer Reihe, zu verändern, weitere Leistungshalbleiter leicht hinzugefügt werden können. Durch die Anordnung der Leistungshalbleiter in einer Reihe kann ein Substrat mit minimaler Breite verwendet werden.

Vorzugsweise verlaufen die elektrisch leitenden Kontaktflächen streifenförmig in Substratlängsrichtung und erstrecken sich besonders bevorzugt jeweils über die gesamte Länge des Substrats. Auf diese Weise wird eine flächige Stromführung über die Substratoberfläche erzielt.

Es ist günstig, einen weiteren in Substratlängsrichtung verlaufenden streifenförmigen elektrischen Kontakt vorzusehen, der als Steuereingang für die Leistungshalbleiter dient. Kommen als Leistungshalbleiter MOS-Transistoren zum Einsatz, sind die Gatewiderstände von Vorteil direkt auf dem als Steuereingang dienenden streifenförmigen Leiter untergebracht.

Bevorzugt werden weitere elektrische Komponenten auf einer Leiterplatte untergebracht, die mit der Anpreßvorrichtung verbunden ist und besonders bevorzugt oberhalb des Substrates angeordnet ist. Die unmittelbare Nähe der weiteren elektrischen Komponenten, beispielsweise von Zwischenkreiskondensatoren, zu den Leistungshalbleitern gewährleistet einen kompakten und niederinduktiven Aufbau.

Vorzugsweise besitzt das Leistungshalbleitermodul mindestens zwei Substrate, die stirnseitig aneinandergereiht werden, so daß die Leistungshalbleiter auf dem ersten Substrat und die Leistungshalbleiter auf dem zweiten Substrat in einer Reihe liegen. Durch die Aneinanderreihung der Substrate an den jeweiligen Stirnseiten kann die reihenförmige Anordnung der Leistungshalbleiter theoretisch beliebig erweitert werden. Die Abmessungen der einzelnen Substrate müssen nicht mehr zwingend nach der Anzahl der unterzubringenden Halbleiterchips ausgewählt werden. Es ist damit möglich, die Substrate auch unter wirtschaftlichen Gesichtspunkten zu gestalten.

Die Erfindung bezieht sich auch auf einen mehrphasigen Umrichter mit mehreren elektrischen Halbbrücken, die jeweils aus zwei in Reihe geschalteten Leistungsschaltern bestehen, wobei die Verbindungen zwischen den zwei Leistungsschaltern jeweils einen Ausgang des Umrichters darstellen.

Ein derartiger Umrichter wird erfindungsgemäß so ausgeführt, daß die Leistungsschalter ein elektrisch isolierendes und thermisch leitendes Substrat, auf dessen Oberfläche Leistungshalbleiter und elektrische Kontaktflächen angeordnet sind, und eine Anpreßvorrichtung aufweisen, mit der die Unterseite des Substrates zumindest teilweise mit einem Kühlkörper in thermischen Kontakt gebracht wird, und daß die Anpreßvorrichtung als elektrische Zuleitung zu den elektrischen Kontaktflächen dient.

Bevorzugt werden die Substrate des Umrichters so angeordnet, daß die elektrischen Kontaktflächen zweier nebeneinander liegender Substrate sich jeweils auf gleichem elektrischen Potential befinden. Besonders bevorzugt ist eine gemeinsame Anpreßvorrichtung für die beiden nebeneinander liegenden Substrate vorgesehen. Durch diesen Aufbau werden die Anzahl der Anpreßvorrichtungen und der gesamte Flächenbedarf des Umrichters minimiert.

Aufgrund der Struktur der Leistungshalbleitermodule können mehrere Module durch geeignete Anordnung leicht zu einem Drehstromumrichter kombiniert werden. Bekannte Drehstromumrichter bestehen aus mindestens drei Halbbrücken, die jeweils aus zwei identischen in Reihe geschalteten Leistungsschaltern bestehen, wobei zwei nicht gleiche Anschlüsse der Leistungsschalter miteinander verbunden sind. Der Verbindungspunkt der Schalter stellt einen motorseitigen Anschluß des Umrichters dar, die beiden übrigen Anschlüsse der Halbbrücke sind entsprechend der Ausführung der Leistungsschalter mit dem Zwischenkreis des Umrichters verbunden.

Mit dem erfindungsgemäßen Aufbau eines Leistungshalbleitermoduls kann eine Halbbrücke einfach realisiert werden, indem zwei Leistungsschalter längsseitig nebeneinander angeordnet werden und mit einem elektrisch leitenden Doppeldruckstück angepreßt und elektrisch verbunden werden. Dieses Druckstück stellt gleichzeitig den Motoranschluß dar.

Die übrigen Halbbrücken werden ebenso angeordnet, jedoch jeweils um 180° verdreht gegeneinander. Dadurch liegen die Zwischenkreisanschlüsse der Halbbrücken mit gleichem Potential nebeneinander, so daß wieder ein elektrisch leitendes Doppeldruckstück eingesetzt werden kann. Dadurch ergibt sich ein einfacher und kompakter Aufbau eines aus mehreren Halbbrücken aufgebauten Umrichters.

Die Erfindung hat gegenüber den bekannten Halbleitermoduln zahlreiche Vorteile. So ermöglicht sie einen äußerst kostengünstigen Aufbau von Leistungshalbleitermodulen, wie z.B. einem Drehstromumrichter. Der Aufbau ist sehr kompakt und erleichtert die direkte Anbindung des Moduls an beispielsweise von dem Modul gesteuerte elektrische Einheiten, z.B. an einen Motor.

Die erfindungsgemäße Möglichkeit, ohne Veränderung der Grundstruktur des Aufbaus mehrere Substrate stirnseitig aneinanderzureihen, erlaubt es, die Anzahl der Leistungshalbleiter pro Einheit theoretisch beliebig zu vergrößern, ohne durch die Substratgröße begrenzt zu sein. Das erfindungsgemäße Leistungshalbleitermodul ist über die Zahl der parallelgeschalteten Leistungshalbleiter bzw. über die Zahl der in Reihe angeordneten Substrate sehr einfach skalierbar. Die Stromtragfähigkeit des Leistungshalbleitermoduls ist durch die variable Anzahl von Leitungshalbleitern bei unveränderter Struktur des Moduls leicht einstellbar. Die Substrate können alle identisch aufgebaut werden und ermöglichen so eine kostengünstige Realisierung des Leistungshalbleitermoduls.

Die Erfindung ermöglicht den einfachen Aufbau von elektrischen Halbbrücken. Hierzu werden zwei Leistungsschalter, beispielsweise MOS-Leistungstransistoren, nebeneinander auf dem Substrat so angeordnet, daß zwei nicht gleiche Anschlüsse der Leistungsschalter verbunden sind. Werden zwei Leistungstransistoren eingesetzt, so liegen z.B. der Drain-Anschluß des ersten Transistors und der Source-Kontakt des zweiten Transistors auf dem gleichen Potential. Dieser gemeinsame Anschluß wird mit einer Anpreßvorrichtung auf den Kühlkörper gepreßt, elektrisch angeschlossen und dient als Zwischenkreisanschluß oder Motoranschluß.

Durch die Kombination mehrerer derartiger Halbbrücken können in einfacher Weise mehrphasige Umrichter realisiert werden. Die Substrate mit den einzelnen Halbbrücken werden so aneinander gereiht, daß elektrische Kontaktflächen, die sich auf dem gleichen Potential befinden, nebeneinander zu liegen kommen, so daß eine gemeinsame Anpreßvorrichtung verwendet werden kann.

Das erfindungsgemäße Aufbaukonzept für Leistungshalbleitermodule ist mit Vorteil in zahlreichen Anwendungen, wie Leistungsstellern aller Art, einsetzbar und sehr gut für den Aufbau eines jeden Leistungsteils für elektrische Antriebe geeignet.

Die Erfindung sowie weitere vorteilhafte Einzelheiten der Erfindung werden im folgenden anhand von in den Zeichnungen dargestellten Ausführungsbeispielen näher erläutert. Hierbei zeigen:
- Figur 1: das elektrische Schaltbild eines Leistungshalbleitermoduls,
- Figur 2: den Aufbau eines der mit Transistoren bestückten Substrate dieses Leistungshalbleitermoduls und
- Figur 3: eine Seitenansicht des gesamten Leistungshalbleitermoduls.

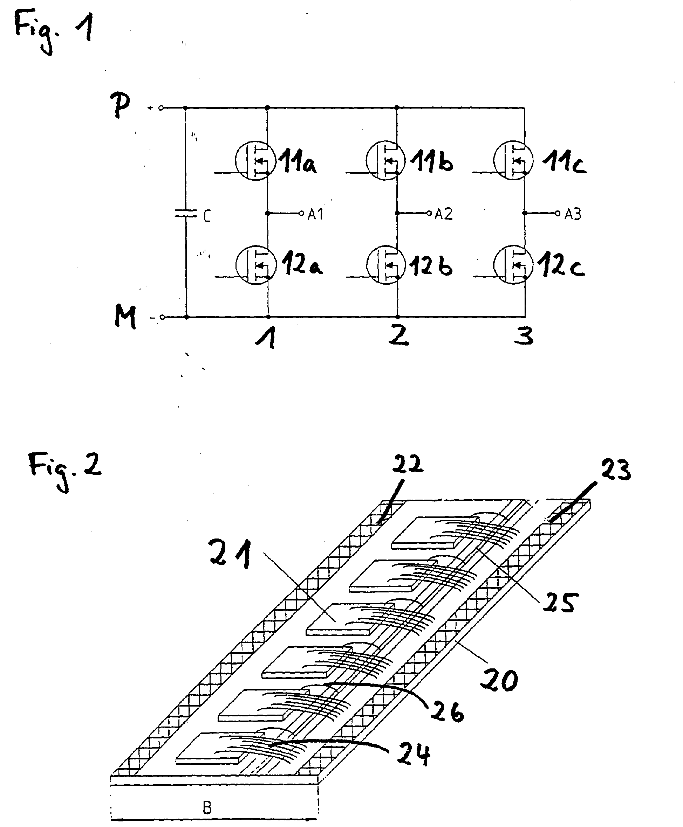

In Figur 1 ist das elektrische Schaltbild eines Drehstromumrichters mit MOS-Leistungstransistoren gezeigt. Die Schaltung weist drei identische Halbbrücken 1, 2, 3 auf, die sich wiederum aus zwei in Reihe geschalteten Leistungsschaltern 11a und 12a, 11b und 12b, 11c und 12c zusammensetzen. Die unteren Schalter 12a,b,c sind mit dem Minuspol M, die oberen Schalter 11a,b,c mit dem Pluspol P eines Zwischenkreises verbunden. Die Verbindungen zwischen den Leistungsschaltern 11a und 12a, 11b und 12b sowie 11c und 12c stellen jeweils einen Ausgang A1, A2, A3 des Umrichters dar.

Alle Leistungsschalter 11a bis c bzw. 12a bis c besitzen identisch aufgebaute Substrate. Durch den identischen Aufbau aller Substrate eines Leistungsmoduls lassen sich diese kostengünstig realisieren.

In Figur 2 ist einer der Leistungsschalter 11a bis c bzw. 12a bis c im Detail gezeigt. Ein keramischer Isolator 20 in Scheibenform, beispielsweise ein DCB-Substrat, dessen Oberflächen metallisch, vorzugsweise mit Kupfer, beschichtet sind, bildet die Grundplatte 20. Auf der einen Oberfläche des Substrates 20 sind Leistungshalbleiter 21 möglichst dicht in einer Reihe angeordnet. Die gegenüberliegende Oberfläche dient als Kontaktfläche zu einem Kühlkörper, über den die als Abwärme anfallende Verlustleistung der Transistoren 21 abgeführt werden kann.

Das Substrat 20 besitzt eine rechteckige Form, wobei die Breite des Substrates 20 möglichst gering gehalten wird und im wesentlichen durch die Abmessungen der Leistungstransistoren 21 vorgegeben ist. Die Leistungskontakte 22 und 23 sowie die Steuerleitung 25 befinden sich möglichst nahe an den Transistoren 21.

Die Leistungstransistoren 21 sind in einer parallel zur Substratlängsachse verlaufenden Reihe möglichst dicht nebeneinander angeordnet. Dadurch ergibt sich ein sehr platzsparender Aufbau, der eine hohe Flexibilität hinsichtlich der Anzahl der auf einem Substrat 20 parallelgeschalteten Leistungshalbleiter 21 bietet, ohne daß die Grundstruktur verändert werden muß.

Das Substrat 20 weist weiterhin zwei sich jeweils über die gesamte Länge des Substrats 20 erstreckende elektrische Kontaktflächen 22 und 23 auf. Die elektrischen Kontaktflächen 22 und 23 dienen als Leistungskontakte für die Leistungshalbleiter 21, an denen jeweils der Drain- und der Sourcekontakt der Leistungshalbleiter 21 angeschlossen werden. Die elektrische Verbindung zwischen dem Leistungskontakt 22 und den Leistungshalbleitern 21 erfolgt über einen sich an der Unterseite der Chips 21 befindenden Anschluß, die Verbindung zum Leistungskontakt 23 wird über Bonddrähte 24 hergestellt. Die Stromführung erfolgt somit flächig über die Substratoberfläche 20.

Schließlich ist eine sich ebenfalls über die ganze Länge des Substrates erstreckende Steuerleitung 25 vorgesehen, an der mittels Bonddrähten 26 der Gatekontakt der Leistungshalbleiter 21 angeschlossen ist.

Jeder der in Figur 2 gezeigten Aufbauten stellt einen der Leistungsschalter 11a bis *c* bzw. 12a bis c dar. Die Kontaktflächen 22 und 23 entsprechen jeweils einem der Ausgänge M1, M2, M3, P1, P2, P3, A1, A2 oder A3. M1, M2 und M3 bezeichnen die mit dem Minuspol M des Zwischenkreises verbundenen Ausgänge der Transistoren 12a bis c, P1, P2 und P3 entsprechend die mit dem Pluspol P verbundenen Ausgänge der Transistoren 11 a bis c.

Wenn die Substrate der Leistungsschalter in der Reihenfolge M1, A1, P1, P2, A2, M2, M3, A3, P3 angeordnet werden, d.h. die Leistungsschalter in der Reihenfolge 12a, 11a, 11b, 12b, 11c, 12c, so befinden sich jeweils zwei nebeneinander liegende Leistungsanschlüsse 22, 23 auf demselben Potential. Dadurch können jeweils zwei nebeneinander liegende Substrate 20 mit einem einzigen elektrisch leitenden Druckstück verbunden werden.

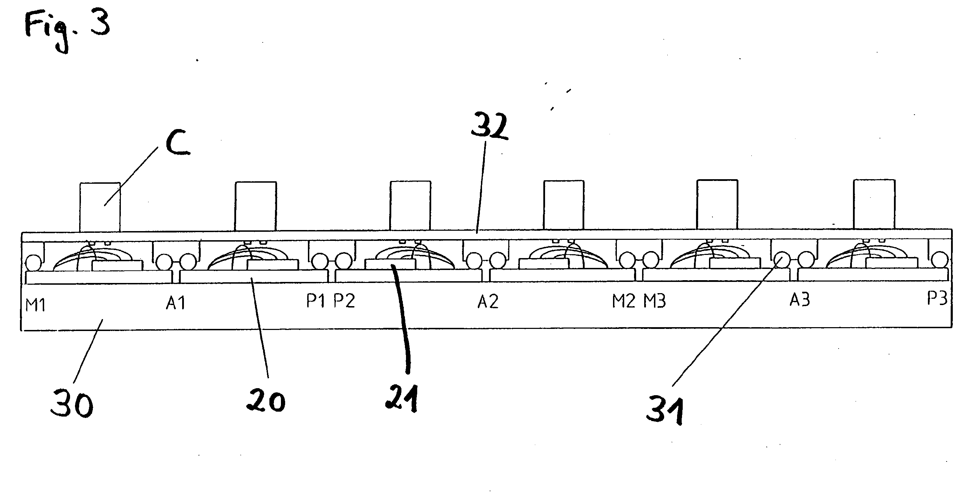

In Figur 3 ist ein derartiger Aufbau in der Seitenansicht zu sehen. Auf einem Kühlkörper 30 sind sechs DCB-Substrate 20 nebeneinander angeordnet. Auf die Substrate 20 sind Leistungshalbleiter 21, wie in Figur 2 gezeigt, aufgelötet und an Leistungs- und Steuerkontakte 22, 23 und 25 angeschlossen. Die streifenförmigen Kontaktflächen 22, 23 und 25 erstrecken sich in Substratlängsrichtung. In Figur 3 entspricht dies der Richtung senkrecht zur Zeichenblattebene.

Die Substrate 20 werden durch elektrisch leitende Druckstücke 31 im Bereich der elektrischen Anschlußflächen 22 und 23 auf den Kühlkörper 30 gepreßt. Die Flächen 22 und 23 dienen sowohl als elektrische Kontaktflächen als auch als Anpreßflächen. Entsprechend üben auch die Druckstücke 31 eine Doppelfunktion aus, nämlich das Anpressen des Substrats 20 an den Kühlkörper 30 und die elektrische Zuleitung zu den Leistungshalbleitern 21.

Aufgrund der geringen Breite B der Substrate 20 genügt es, die Substrate 20 nur auf den Längsseiten, d.h. im Bereich der Kontaktflächen 22 und 23, auf den Kühlkörper 30 zu pressen.

Die Druckstücke 31 dienen gleichzeitig zur Aufnahme einer über alle Substrate 20 durchgehenden Leiterplatte 32, auf der die Zwischenkreiskondensatoren C und gegebenenfalls weitere Komponenten, wie zum Beispiel Treiberschaltungen für die Leistungshalbleiter 11a bis c bzw. 12a bis c, untergebracht sind. Durch den geringen Abstand zwischen den Substraten 20 und der Leiterplatte 32 ergibt sich ein niederinduktiver Aufbau, der insbesondere durch die flächige Ausbildung der gesamten Leistungsverdrahtung begünstigt wird. Die Steuerleitung 25 ist über nicht dargestellte Kontakte mit der darüberliegenden Leiterplatte 32 verbunden.

## Patentansprüche

1. Leistungshalbleitermodul mit einem elektrisch isolierenden und thermisch leitenden Substrat, auf dessen Oberfläche elektrische Kontaktflächen und mindestens ein mit diesen elektrisch leitend verbundener Leistungshalbleiter angeordnet sind, und mit einer Anpreßvorrichtung, mit der die Unterseite des Substrates zumindest teilweise mit einem Kühlkörper in thermischen Kontakt gebracht wird, **dadurch gekennzeichnet, daß** die Anpreßvorrichtung (31) als elektrische Zuleitung zu den elektrischen Kontaktflächen (22, 23) dient.

2. Leistungshalbleitermodul nach Anspruch 1, **dadurch gekennzeichnet, daß** mehrere Leistungshalbleiter (21) vorgesehen sind, die in einer Reihe nebeneinander angeordnet sind.

3. Leistungshalbleitermodul nach einem der Ansprüche 1 oder 2, **dadurch gekennzeichnet, daß** sich die elektrisch leitenden Kontaktflächen (22, 23) jeweils über die gesamte Länge des Substrats (20) erstrecken.

4. Leistungshalbleitermodul nach einem der Ansprüche 1 bis 3, **dadurch gekennzeichnet, daß** ein weiterer in Substratlängsrichtung verlaufender streifenförmiger elektrischer Kontakt (25) vorgesehen ist.

5. Leistungshalbleitermodul einem der Ansprüche 1 bis 4, **dadurch gekennzeichnet, daß** eine mit der Anpreßvorrichtung (31) verbundene Leiterplatte (32) zur Aufnahme weiterer elektrischer Komponenten (C) vorgesehen ist.

6. Leistungshalbleitermodul nach einem der Ansprüche 1 bis 5, **dadurch gekennzeichnet, daß** mindestens zwei Substrate (20) vorgesehen sind, die stirnseitig aneinandergereiht werden, so daß die Leistungshalbleiter auf dem ersten Substrat und die Leistungshalbleiter auf dem zweiten Substrat in einer Reihe liegen.

7. Leistungshalbleitermodul nach einem der Ansprüche 1 bis 6, **dadurch gekennzeichnet, daß** mit einer elektrischen Kontaktfläche zwei nicht gleiche Anschlüsse zweier Leistungshalbleiter elektrisch leitend verbunden sind.

8. Leistungshalbleitermodul nach einem der Ansprüche 1 bis 7 mit mindestens zwei Substraten, **dadurch gekennzeichnet, daß** die Substrate (20) so angeordnet werden, daß nebeneinander liegende elektrische Kontaktflächen benachbarter Substrate (20) jeweils auf gleichem elektrischen Potential liegen.

9. Leistungshalbleitermodul nach Anspruch 8, **dadurch gekennzeichnet, daß** zwei nebeneinander liegende elektrische Kontaktflächen (20) eine gemeinsame Anpreßvorrichtung (31) aufweisen.

10. Mehrphasiger Umrichter mit mehreren elektrischen Halbbrücken, die jeweils aus zwei in Reihe geschalteten Leistungsschaltern bestehen, wobei die Verbindungen zwischen den zwei Leistungsschaltern jeweils einen Ausgang des Umrichters darstellen, die Leistungsschalter (11a,b,c, 12a,b,c) ein elektrisch isolierendes und thermisch leitendes Substrat (20), auf dessen Oberfläche Leistungshalbleiter (21) und elektrische Kontaktflächen (22, 23) angeordnet sind, und eine Anpreßvorrichtung (31) aufweisen, mit der die Unterseite des Substrates (20) zumindest teilweise mit einem Kühlkörper (30) in thermischen Kontakt gebracht wird, **dadurch gekennzeichnet, daß** die Anpreßvorrichtung (31) als elektrische Zuleitung zu den elektrischen Kontaktflächen (22, 23) dient

11. Mehrphasiger Umrichter nach Anspruch 10, **dadurch gekennzeichnet, daß** die Substrate (20) so angeordnet werden, daß nebeneinander liegende elektrische Kontaktflächen benachbarter Substrate (20) jeweils auf gleichem elektrischen Potential liegen.

12. Mehrphasiger Umrichter nach einem der Ansprüche 10 oder 11, **dadurch gekennzeichnet, daß** zwei nebeneinander liegende Substrate (20) eine gemeinsame Anpreßvorrichtung (31) aufweisen.

## Claims

1. Power semiconductor module comprising an electrically insulating and thermally conductive substrate, on the surface of which are arranged electrical contact areas and at least one power semiconductor that is electrically conductively connected thereto, and comprising a press-on device by means of which the underside of the substrate is at least partly brought into thermal contact with a heat sink, **characterized in that** the press-on device (31) serves as electrical supply lead to the electrical contact areas (22, 23).

2. Power semiconductor module according to Claim 1, **characterized in that** a plurality of power semiconductors (21) are provided which are arranged in a series alongside one another.

3. Power semiconductor module according to either of Claims 1 and 2, **characterized in that** the electrically conductive contact areas (22, 23) in each case extend over the entire length of the substrate (20).

4. Power semiconductor module according to one of Claims 1 to 3, **characterized in that** a further strip-type electrical contact (25) running in the longitudinal direction of the substrate is provided.

5. Power semiconductor module according to one of Claims 1 to 4, **characterized in that** provision is made of a printed circuit board (32) for receiving further electrical components (C), said printed circuit board being connected to the press-on device (31).

6. Power semiconductor module according to one of Claims 1 to 5, **characterized in that** at least two substrates (20) are provided which are strung together on the end side, such that the power semiconductors on the first substrate and the power semiconductors on the second substrate lie in a series.

7. Power semiconductor module according to one of Claims 1 to 6, **characterized in that** two non-identical terminals of two power semiconductors are electrically conductively connected to an electrical contact area.

8. Power semiconductor module according to one of Claims 1 to 7 comprising at least two substrates, **characterized in that** the substrates (20) are arranged in such a way that electrical contact areas of adjacent substrates (20) that lie alongside one another are in each case at the same electrical potential.

9. Power semiconductor module according to Claim 8, **characterized in that** two electrical contact areas (22, 23) that lie alongside one another have a common press-on device (31).

10. Polyphase converter comprising a plurality of electrical half-bridges each comprising two series-connected power switches, the connections between the two power switches in each case constituting an output of the converter, the power switches (11a, b, c, 12a, b, c) having an electrically insulating and thermally conductive substrate (20), on the surface of which are arranged power semiconductors (21) and electrical contact areas (22, 23), and a press-on device (31), by means of which the underside of the substrate (20) is at least partly brought into thermal contact with a heat sink (30), **characterized in that** the press-on device (31) serves as electrical supply lead to the electrical contact areas (22, 23).

11. Polyphase converter according to Claim 10, **characterized in that** the substrates (20) are arranged in such a way that electrical contact areas of adjacent substrates (20) that lie alongside one another are in each case at the same electrical potential.

12. Polyphase converter according to either of Claims 10 and 11, **characterized in that** two substrates (20) that lie alongside one another have a common press-on device (31).

## Revendications

1. Dispositif semi-conducteur de puissance pourvu d'un substrat électriquement isolant et conducteur thermiquement, à la surface duquel sont disposés des surfaces de contact électriques et au moins un semi-conducteur de puissance relié à celles-ci de manière électriquement conductrice, et d'un dispositif de pression, avec lequel la partie inférieure du substrat est mise en contact thermique au moins partiellement avec un dissipateur de chaleur, **caractérisé en ce que** le dispositif de pression (31) fait office de conducteur électrique avec les surfaces de contact électriques (22, 23).

2. Dispositif semi-conducteur de puissance selon la revendication 1, **caractérisé en ce que** plusieurs semi-conducteurs (21) de puissance sont prévus, disposés en série les uns à côté des autres.

3. Dispositif semi-conducteur de puissance selon l'une quelconque des revendications 1 ou 2, **caractérisé en ce que** les surfaces de contact électriquement conductrices (22, 23) s'étendent à chaque fois sur toute la longueur du substrat (20).

4. Dispositif semi-conducteur de puissance selon l'une quelconque des revendications 1 à 3, **caractérisé en ce qu'**un autre contact électrique (25) en forme de bande s'étendant dans le sens longitudinal du substrat est prévu.

5. Dispositif semi-conducteur de puissance selon l'une quelconque des revendications 1 à 4, **caractérisé en ce qu'**une plaque conductrice (32) connectée au dispositif de pression (31) est prévue pour recevoir d'autres composants électriques (C).

6. Dispositif semi-conducteur de puissance selon l'une quelconque des revendications 1 à 5, **caractérisé en ce qu'**au moins deux substrats (20) sont prévus, disposés face à face, de sorte que les semi-conducteurs de puissance sur le premier substrat et les semi-conducteurs de puissance sur le second substrat sont disposés en série.

7. Dispositif semi-conducteur de puissance selon l'une quelconque des revendications 1 à 6, **caractérisé en ce que** deux raccords non similaires de deux semi-conducteurs de puissance sont connectés de manière électriquement conductrice à une surface de contact électrique.

8. Dispositif semi-conducteur de puissance selon l'une quelconque des revendications 1 à 7 pourvu d'au moins deux substrats, **caractérisé en ce que** les substrats (20) sont disposés de telle sorte que des surfaces de contact électriques de substrats (20) voisins, disposées l'une à côté de l'autre, reposent à chaque fois sur le même potentiel électrique.

9. Dispositif semi-conducteur de puissance selon la revendication 8, **caractérisé en ce que** deux surfaces de contact électriques (22, 23) disposées l'une à côté de l'autre présentent un dispositif de pression (31) commun.

10. Redresseur multiphase pourvu de plusieurs demi-ponts électriques, composés à chaque fois de deux interrupteurs de puissance commutés en série, les connexions entre les deux interrupteurs de puissance constituant à chaque fois une sortie du redresseur, les interrupteurs de puissance (11a,b,c, 12a,b,c) présentant un substrat électriquement isolant et conducteur thermiquement (20), à la surface duquel sont disposés des semi-conducteurs de puissance (21) et des surfaces de contact électriques (22, 23), et un dispositif de pression (31), avec lequel la partie inférieure du substrat (20) est mise en contact thermique au moins partiellement avec un dissipateur de chaleur (30), **caractérisé en ce que** le dispositif de pression (31) fait office de conducteur électrique avec les surfaces de contact électriques (22, 23).

11. Redresseur multiphase selon la revendication 10, **caractérisé en ce que** les substrats (20) sont disposés de telle sorte que des surfaces de contact électriques de substrats (20) voisins, disposées l'une à côté de l'autre, reposent à chaque fois sur le même potentiel électrique.

12. Redresseur multiphase selon l'une quelconque des revendications 10 ou 11, **caractérisé en ce que** deux substrats (20) disposés l'un à côté de l'autre présentent un dispositif de pression (31) commun .
